# EUROPEAN PATENT APPLICATION

(11) **EP 1 804 293 A1**
(43) Date of publication of application: **04.07.2007**
(21) Application number: 05425942.9
(22) Date of filing: 30.12.2005
(51) Int. Cl.: H01L 27/115, H01L 21/8247, H01L 21/768

(54) **Process for manufacturing a non volatile memory electronic device**

(71) Applicant: STMicroelectronics S.r.l., 20041 Agrate Brianza (Milano) (IT)
(72) Inventor: Brazzelli, Daniela, 21052 Busto Arsizio (Varese) (IT); Servalli, Giorgio, 24040 Ciserano (Bergamo) (IT); Carollo, Enzo, 36030 Montecchio Prec., (Vicenza) (IT)
(74) Representative: Ferrari, Barbara

(57) **Abstract**

Process for manufacturing a non volatile electronic device integrated on a semiconductor substrate (2) which comprises a plurality of non volatile memory cells (1) being organised in matrix and an associated circuitry, comprising the steps of:
- forming gate electrodes (7) of the memory cells (1) projecting from the semiconductor substrate (2), each of the gate electrodes (7) comprising a first dielectric layer (3), a floating gate electrode (4), a second dielectric layer (5) and a control gate electrode (6) coupled to a respective word line, at least one first portion of the gate electrodes (7) of the memory cells (1) being separated from each other by first openings (15) of a first width (D),
- forming source and drain regions (8) of the memory cells (1) in the semiconductor substrate (2), the source and drain regions (8) of the memory cells (1) being aligned with the gate electrodes (7) of the memory cells (1),
- forming gate electrodes of transistors of the circuitry projecting from the semiconductor substrate (2), each of the gate electrodes of the circuitry comprising a first dielectric layer of the circuitry and a first conductive layer of the circuitry,
- forming source and drain regions of the transistors in the semiconductor substrate (2), the source and drain regions of the transistors being aligned with the gate electrodes (7) of the transistors, the process being characterised in that it comprises the following steps:

- depositing, on the whole device, a third non conform dielectric layer (10) so as to completely fill in the first openings (15) and to form air-gaps (16) between the gate electrodes belonging to the first portion of the gate electrodes (7) of the memory cells (1).

## Description

### Field of application

The present invention relates to a process for manufacturing a non volatile memory electronic device integrated on a semiconductor substrate.

More specifically, the invention relates to a process for manufacturing a non volatile memory electronic device integrated on a semiconductor substrate comprising a plurality of non volatile memory cells organised in matrix and an associated circuitry, comprising the steps of:
- forming gate electrodes of said memory cells projecting from said semiconductor substrate, each of said gate electrodes comprising a first dielectric layer, a first conductive layer, a second dielectric layer and a second conductive layer, at least one first portion of said gate electrodes of said memory cells being separated from each other by first openings of a first width,
- forming source and drain regions of said memory cells in said semiconductor substrate, said source and drain regions of said memory cells being aligned with said gate electrodes of said memory cells,
- forming gate electrodes of transistors of said circuitry projecting from said semiconductor substrate, each of said gate electrodes of said circuitry comprising a first dielectric layer of said circuitry and a first conductive layer of said circuitry,
- forming source and drain regions of said transistors in said semiconductor substrate, said source and drain regions of said transistors being aligned with said gate electrodes of said transistors.

The invention also relates to a non volatile memory electronic device integrated on a semiconductor substrate comprising a plurality of non volatile memory cells organised in matrix and an associated circuitry, each cell comprising:
- a gate electrode projecting from said semiconductor substrate comprising a first dielectric layer, a first conductive layer, a second dielectric layer and a second conductive layer,
- source and drain regions formed in said semiconductor substrate and aligned with said gate electrode.

The invention particularly, but not exclusively, relates to a process for manufacturing a non volatile memory electronic device comprising memory cells having a floating gate electrode with a reduced reading disturbance and the following description is made with reference to this field of application by way of illustration only.

### Prior art

As it is well known, non volatile memory electronic devices, for example of the Flash type, integrated on semiconductor substrate comprise a plurality of non volatile memory cells organised in matrix, i.e. the cells are organised in rows, called word lines, and columns, called bit lines.

Each single non volatile memory cell comprises a MOS transistor wherein the gate electrode, arranged above the channel region, is floating, i.e. it has a high continuous impedance towards all the other terminals of the same cell and of the circuit wherein the cell is inserted.

The cell also comprises a second electrode, called of control gate, which is capacitively coupled to the floating gate electrode by means of an intermediate dielectric layer, so called interpoly. This second electrode is driven by means of suitable control voltages. The other electrodes of the transistor are the usual drain and source terminals.

The cells belonging to a same word line share the electric line which drives the respective control gates, while the cells belonging to a same bit line share the drain terminals.

Conventionally, memory electronic devices also comprise a control circuitry associated with the matrix of memory cells. The control circuitry comprises conventional MOS transistors each having a source region and a drain region separated by a channel region. A gate electrode is then formed on the channel region and it is insulated therefrom by means of a gate oxide layer.

It is also known that the continuous scaling of the floating gate memory cells causes an increase of the reading disturbances of these memory cells linked to capacitive couplings between adjacent floating gate electrodes.

According to the most common schemes of the process used to form the cell matrix, and i.e. with NAND and NOR architectures, a fundamental part of these reading disturbances is due to the coupling between floating gate electrodes of adjacent wordlines. This coupling between floating gate electrodes depends on the dimension of the floating gate electrode and, to a first approximation, it is proportional to the product of the width W of the memory cells and of the thickness of the polysilicon which forms the floating gate electrode. This coupling between floating gate electrodes also depends on the distance between the floating gate electrodes and on the dielectric constant of the materials which insulate the floating gate electrodes themselves from each other.

In particular, for the cells formed with architectures of the NAND type the coupling involves all the adjacent wordlines, since in this configuration the wordlines are uniformly spaced in the memory matrix, while in the cells formed with architectures of the NOR type with SAS architecture (Self-Aligned Source) the coupling involves only the wordlines which share a sourceline, since the wordlines of the cells sharing a drain contact are generally more spaced from each other to allow the housing of the drain contact serving also as electrostatic separator.

Moreover, the scaling of the reading disturbance due to the coupling between floating gate electrodes of adjacent wordlines is particularly remarkable in case of multilevel devices.

It is also known, from US patent No. 6,703,314, to manufacture self aligned contacts in a semiconductor device, wherein voids are formed between conductive structures.

The technical problem underlying the present invention is that of defining the process sequence for manufacturing a memory electronic device comprising a plurality of non volatile memory cells of the floating gate type having such characteristics as to allow to decrease the reading disturbances still limiting the devices formed according to the prior art.

### Summary of the invention

The solution idea underlying the present invention is that of introducing suitable air-gaps between the floating gate electrodes.

On the basis of this solution idea the technical problem is solved by a process as previously indicated and defined by the characterising part of claim 1.

The characteristics and the advantages of the device according to the invention will be apparent from the following description of an embodiment thereof given by way of indicative and non limiting example with reference to the annexed drawings.

### Brief description of the drawings

In these drawings:
- figures 1A to 9A are respective schematic section views of an integrated circuit portion during the successive steps of a first embodiment of a manufacturing process according to the present invention;
- figures 1B to 9B are respective schematic section views of an integrated circuit portion during the successive steps of a second embodiment of a manufacturing process according to the present invention;
- figures 10A and 11A are respective schematic section views of an integrated circuit portion during the successive steps of a first version of the first embodiment of a manufacturing process according to the present invention;
- figures 10B and 11B are respective schematic section views of an integrated circuit portion during the successive steps of a first version of the second embodiment of a manufacturing process according to the present invention;
- figures 12 and 13 are respective schematic section views of an integrated circuit portion during the successive steps of a second version of the second embodiment of a manufacturing process according to the present invention.
- figure 14 is a schematic view from above of an integrated circuit portion of figure 6A and 6B.

### Detailed description

With reference to these figures, a process for manufacturing a non volatile memory electronic device is now described.

The process steps and the structures described hereafter do not form a complete process flow for the manufacture of integrated circuits.

The present invention can be put into practice together with the techniques for manufacturing integrated circuits currently used in the field, and only those process steps being commonly used and necessary for the comprehension of the present invention will be included.

The figures showing cross sections of an integrated circuit portions during the manufacturing are not drawn to scale, but they are instead drawn so as to show the important characteristics of the invention.

The process steps are then described for manufacturing a non volatile memory electronic device integrated on a semiconductor substrate which comprises a plurality of non volatile memory cells organised in matrix, i.e. the cells are organised in rows, called word lines, and columns, called bit lines.

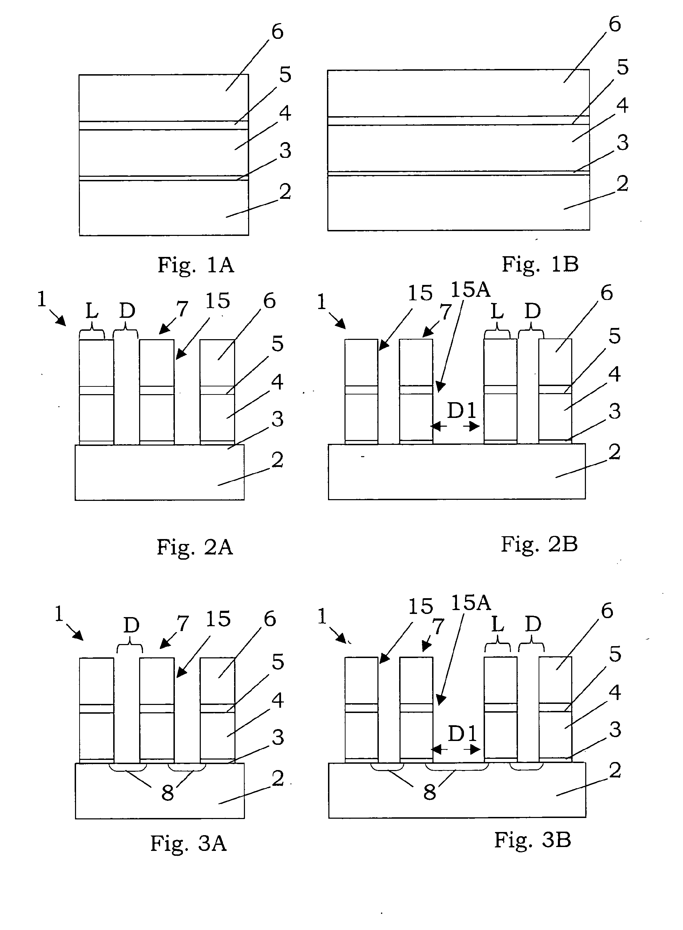

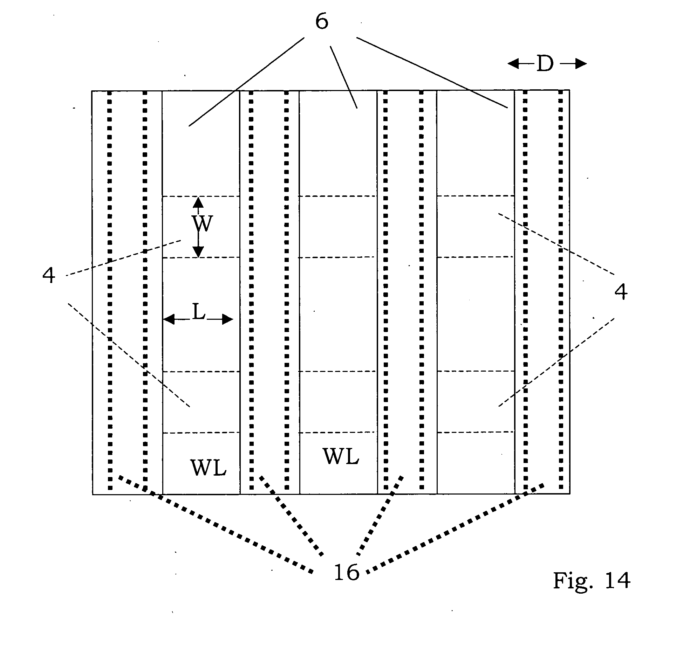

In particular, with reference to figures 1A to 9A and 14, the process steps are shown for manufacturing a memory electronic device comprising a plurality of memory cells 1 organised with NAND architecture and integrated on a semiconductor substrate 2, these steps comprising:
- forming active areas for the memory cells 1 delimited by a suitable insulation layer not shown in the figures;
- forming, in sequence on the whole semiconductor substrate 2, at least one first dielectric layer 3, for example of active oxide also known as tunnel oxide, a first conductive layer 4, for example of polysilicon,
- forming a first protective mask on the first conductive layer 4,
- etching the first conductive layer 4 through the first mask, to define floating gate electrodes of the memory cells 1 having width W along a first direction, as shown in figure 14, these floating gate electrodes also having reference number 4,
- forming, in sequence on the whole semiconductor substrate 2, at least one second dielectric layer 5, for example interpoly oxide and a second conductive layer 6, for example of polysilicon,
- forming a second protective mask, on the second conductive layer 6, to define gate electrodes of the memory cells 1 in a second direction perpendicular to the first direction,
- etching, in sequence, the second conductive layer 6, the second dielectric layer 5, the first conductive layer 4 and the first dielectric layer 3 through the second mask until the semiconductor substrate 2 is exposed so as to form openings 15 of width D and to complete the gate electrodes 7 of the memory cells 1 having a length L as shown in figure 2A.

In particular, with this latter etching step, in the second conductive layer 6 the word lines WL of the matrix of memory cells 1 are defined. The portions of word lines WL aligned with the floating gate electrodes 4 form control gate electrodes of the memory cells which are also indicated with reference number 6.

For an architecture of the NAND type the gate electrodes 7 and thus the wordlines connecting them are uniformly spaced, usually with the distance which is equal to the width D of the openings 15 and is equal to the minimum allowed by the lithographic process used since contacts between the memory cells 1 are not provided. For example for a process of 90nm, i.e. wherein the minimum photolithographic resolution which can be obtained is equal to 90 nm, the distance D is for example equal to 90nm while the length L is equal to 90nm.

Moreover, in a known way, in the circuitry of the matrix at least one first dielectric layer of the circuitry, for example oxide, and one first conductive layer of the circuitry, for example polysilicon, are formed to manufacture gate electrodes of transistors of the circuitry, by means of a conventional photolithographic technique and successive etching of the first conductive layer of the circuitry and of the first dielectric layer of the circuitry.

Advantageously, the first conductive layer of the circuitry is formed by means of the second conductive layer 6 used to form the memory cells 1.

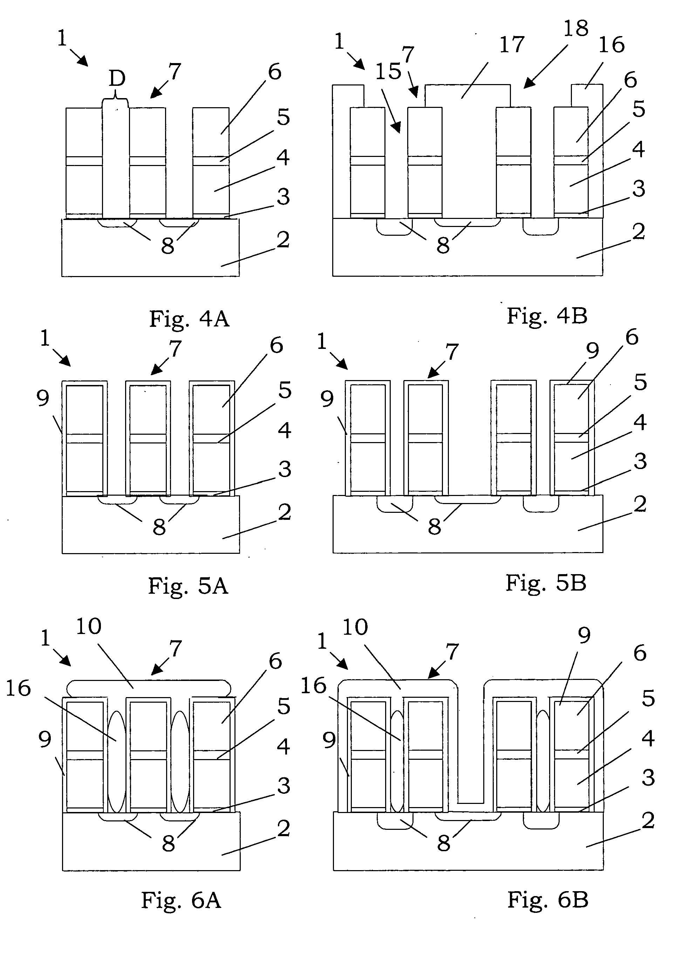

As shown in figures 3A and 4A, the implants are carried out being self aligned to the gate electrodes 7 to form the source and drain regions 8 of the memory cells 1, optimised according to the operation needs of the memory cells 1. In particular these source and drain regions 8 are optimised to allow the sole reading of the memory cells arranged with NAND configuration.

An implant step is then carried out to form first portions of source and drain regions of the circuitry transistors.

Advantageously, the memory cells 1 and the circuitry transistors are sealed by means of a step of re-oxidation the source and drain regions 8 and the formation of a third thin dielectric layer, if any, for example of oxide, as shown in figure 5A. The group of the oxide layer formed by means of the re-oxidation step and of the dielectric layer deposited will be indicated with reference number 9.

Thus, once the gate electrodes 7 of the memory cells 1 have been completely formed, as described, in a fully conventional way, according to the invention, on the whole device, a fourth non conform dielectric layer 10 is deposited, as shown in figure 6A.

Due to the poor filling capacities of the fourth dielectric layer 10 and of a marked over-hang on the high part of the memory cells 1, the openings 15 are only "plugged" or closed on top and they are not completely filled in, with the consequent creation of air-gaps 16 which insulate the gate electrodes 7 of the memory cells 1 themselves from each other. The presence of the air-gaps 16 between the gate electrodes 7 drastically reduces the average dielectric constant between the gate electrodes 7 of the adjacent memory cells 1, allowing a significant scaling of the reading disturbance relative to cells belonging to adjacent wordlines. In fact these air-gaps 16 have a unitary dielectric constant which is equal to a fourth of the one of the silicon oxide layers and to a seventh of the one of the silicon nitride layers which are materials commonly used as filling layers of the memory matrix.

Advantageously, the fourth dielectric layer 10 is a layer of material having significant over-hang or a layer with low step coverage capacity i.e. with low capacity of filling slots.

For example, the fourth dielectric layer 10 is formed by a nitride layer or by an oxide layer or by a oxynitride layer of the non conform type.

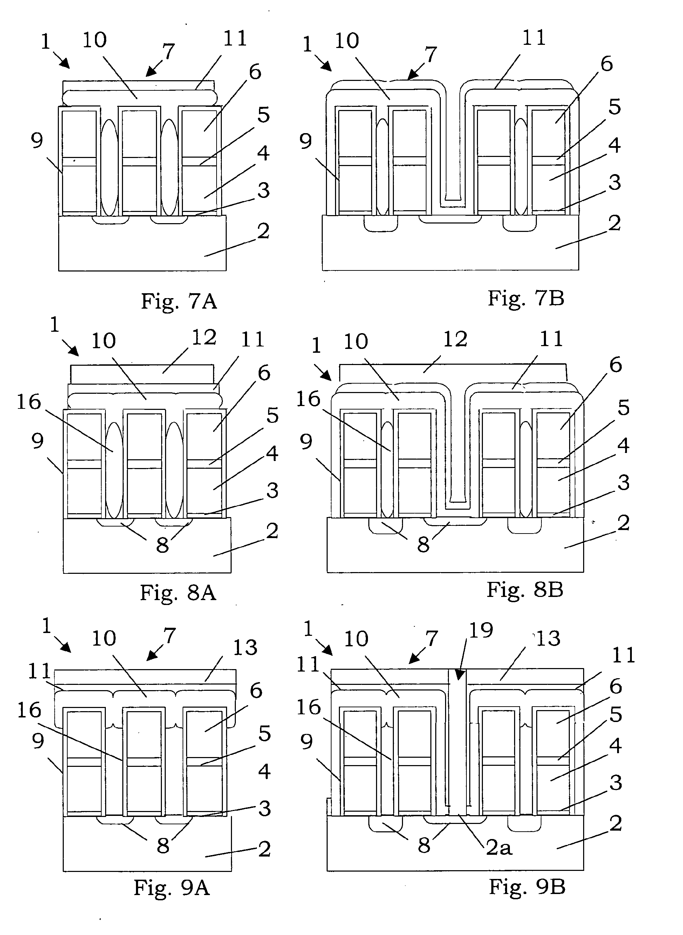

Advantageously, on the fourth dielectric layer 10 a fifth dielectric layer 11 with a high step coverage is deposited i.e. with a high covering capacity, as shown in figure 7A.

Advantageously, this fifth dielectric layer 11 is formed by an oxide or nitride layer or silicon oxynitride.

Advantageously from the combination of the fourth dielectric layer 10 and of the fifth dielectric layer 11, which can be formed separately or by means of a single integrated deposition, also the height at which the air-gaps 16 are formed inside the openings 15 can be controlled.

Advantageously, the fourth dielectric layer 10 and the fifth dielectric layer 11, if present, are used to form the spacers of the circuitry transistors. In fact the circuitry transistors are more spaced from each other with respect to the memory cells 1 and thus they are much less affected by the filling problems linked to the fourth dielectric layer 10, therefore this layer completely covers the gate electrodes of the circuitry transistors and the semiconductor substrate 2 not covered by these gate electrodes.

At this point the steps for completing the spacers of the circuitry transistors can be formed by means of two different versions aimed at preserving the air-gaps 16 formed in the memory cells 1.

In particular, as shown in figure 8A, on the memory cells 1 a mask 12 is formed, for example of resist, which protects the memory cells 1 during an etching step of the fourth dielectric layer 10 and of the fifth dielectric layer 11 to form spacers on the side walls of the circuitry transistors. This etching step is carried out until the dielectric layer 9 is exposed. Subsequently, a mask 12 is removed.

Once the definition of the circuitry transistors is conventionally completed, for example with further implant steps to form second source and drain portions aligned with the spacers and more doped with respect to the first portions of the source and drain regions, after having carried out a removal step of the dielectric layer 9, if any, a salicide layer 14 is formed on the surface portions of the gate electrodes of the circuitry transistors and on the circuitry exposed portions of the semiconductor substrate 2.

This salicide layer 14 is not instead formed in matrix since covered by the fourth dielectric layer 10.

Subsequently, at least one sixth premetal dielectric layer 13 is deposited on the whole device.

Further openings are then defined in the sixth premetal dielectric layer 13 to form contacts in the circuitry.

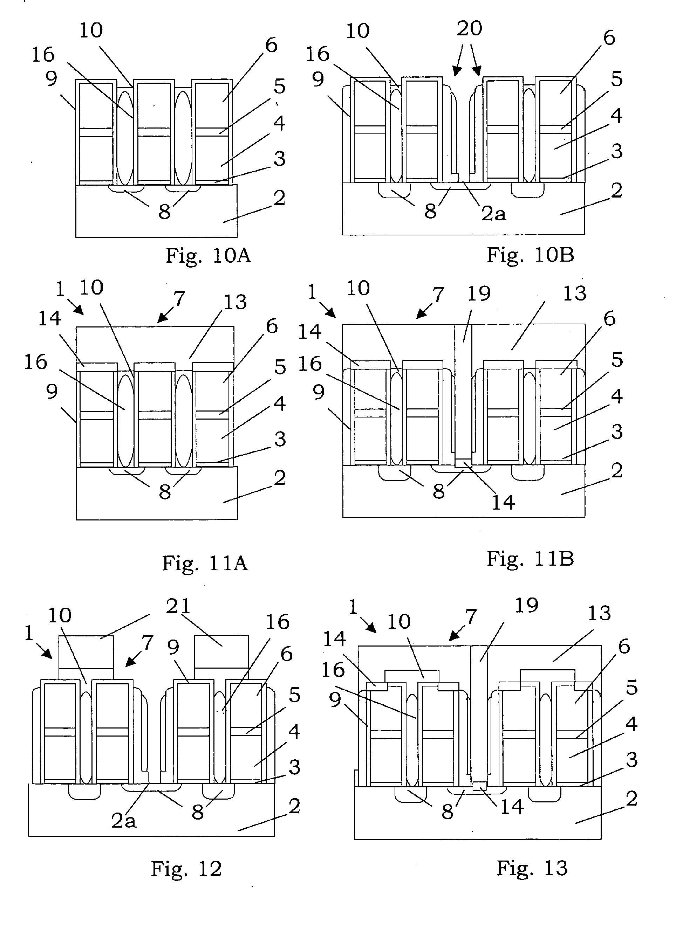

A second embodiment to complete the spacers of the circuitry transistors is shown with reference to figures 10A and 11A.

In particular, the etching step of the fourth dielectric layer 10 and of the fifth dielectric layer 11, if present, for the formation of the spacers of the circuitry transistors, is carried out on the whole device without the use of masks.

In particular the etching step of the fourth dielectric layer 10 completely removes this fourth dielectric layer 10 from a surface portion of the gate electrodes 7, as shown in figure 10A, from surface portions of the gate electrodes of the circuitry transistors, from portions of the semiconductor substrate in circuitry non covered by the gate electrodes and spacers of the circuitry transistors. This etching step is carried out until the dielectric layer 9 is exposed.

Therefore in the portions of the memory electronic device wherein the air-gaps 16 are created, the thickness of the fourth dielectric layer 10, and of the fifth dielectric layer 11, if any, must be sufficient to ensure that the etching step of the circuitry spacers leaves the air-gaps 16 protected.

Once the definition of the circuitry transistors has been conventionally completed, for example with further implant steps to form second portions of the source and drain regions aligned with the spacers and more doped with respect to the first portions of the source and drain regions, after having carried out a removal step of the dielectric layer 9 a salicide layer 14 is formed in circuitry, if any, and on the gate 7 electrodes of the memory cells.

This salicide layer 14 is not instead formed on the source and drain regions of the matrix since covered by the fourth dielectric layer 10.

Subsequently at least one sixth premetal dielectric layer 13 is formed on the whole device as shown in figure 11A.

Further openings are then defined in the sixth premetal dielectric layer 13 to form contacts in the circuitry.

With reference to figures 1B to 11B, 12, 13 and 14, the steps are shown to manufacture a memory electronic device comprising a plurality of memory cells 1 organised instead with NOR architecture integrated on a semiconductor substrate 2 which house a contact inside the memory matrix.

In the following description structurally and functionally elements being identical with respect to the process to manufacture memory cells 1 organised instead with NOR architecture described with reference to figures 1A-11A will be given the same reference numbers.

In particular, the manufacturing process comprises the steps of:
- forming active areas for the memory cells 1 delimited by a suitable insulation layer not shown in the figures;
- forming, in sequence on the whole semiconductor substrate 2, at least one first dielectric layer 3, for example of active oxide also known as tunnel oxide, one first conductive layer 4, for example of polysilicon,
- forming a first protective mask, on the first conductive layer 4,
- etching the first conductive layer 4 through the first mask, to define floating gate electrodes of the memory cells 1 of width W along a first direction, as shown in figure 14, these floating gate electrodes being also indicated with reference number 4,
- forming, in sequence on the whole semiconductor substrate 2, at least one second dielectric layer 5, for example interpoly oxide and one second conductive layer 6, for example polysilicon,
- forming a second protective mask, on the second conductive layer 6, to define the gate electrodes of length L of the memory cells 1 in a second direction for example perpendicular to the first direction,
- etching, in sequence, the second conductive layer 6, the second dielectric layer 5, the first conductive layer 4 and the first dielectric layer 3 through the second mask until portions of the semiconductor substrate 2 are exposed so as to form first openings 15 of width D and second openings 15A of width D 1.

In particular, with this latter etching step, in the second conductive layer 6 the word lines WL of the matrix of memory cells 1 are defined. The portions of word lines WL aligned with the floating gate electrodes 4 form control gate electrodes of the memory cells also indicated with reference number 6.

After having formed the word lines, a first portion of gate electrodes 7 of the memory cells 1 is then formed, and thus word lines, which are spaced from each other by a distance which is equal to the width D of the openings 15, and a second portion of gate electrodes 7 of the memory cells 1, and thus word lines, are spaced from each other by a distance which is equal to the width D1 of the openings 15A, these electrodes 7 of the memory cells 1 having a length L as shown in figure 2B.

In particular, the width D 1 is greater than the width D, since it must be wide enough to house a contact of the matrix of cells of the memory electronic device.

For an architecture of the NOR type the width D of the openings 15 is determined by the minimum source line resistance which can be tolerate and it must be equal or higher than the minimum allowed by the lithographic process used. For example for a process of 90nm the distance D is equal to 120nm. The distance D1 must provide the presence of the drain contact and it is for example equal to 300nm. The length L depends on the characteristics of the channel region and on the junctions of the cell and it is typically equal to the double of the minimum allowed by the lithographic process used, for example of 180nm for process of 90nm.

Moreover, in a known way, in the circuitry associated with the memory matrix at least one first circuitry dielectric layer of the circuitry, for example oxide, and one first conductive layer of the circuitry, for example polysilicon, are formed to manufacture gate electrodes of the circuitry transistors, by using a conventional photolihographic technique and successive etching of the first conductive layer of the circuitry and of the first dielectric layer of the circuitry.

Advantageously, the first conductive layer of the circuitry and the first dielectric layer of the circuitry are formed by means of the second conductive layer 6, the second dielectric layer 5 used to form the memory cells 1.

As shown in figures 3B, the self-aligned implants are carried out through the openings 15 and 15A to form source and drain regions 8 of the memory cells 1 aligned with the gate electrodes 7, and optimised according to the operation needs of the memory cells 1, in particular to allow the reading and the programming for Channel Hot Electrons of the memory cells with NOR architecture.

Advantageously, by means of a successive implant step first portions of source and drain regions of the circuitry transistors are formed.

As shown in figure 4B a photolithographic mask 17 is formed on the whole device being provided with third openings 18 aligned with first openings 15. Through these third openings 18, in a known way, a portion of the matrix insulation layer is removed to define a common source region of the memory matrix and a common source line is implanted in the semiconductor substrate 2, more doped with respect to the previously formed source and drain regions 8.

Advantageously, the memory cells 1 and the circuitry transistors are sealed by means of a re-oxidation step of the source and drain regions 8 and the formation of a third thin dielectric layer, if any, for example of oxide, as shown in figure 5B. The group of the oxide layer formed by means of the re-oxidation step and of the dielectric layer deposited will be indicated with reference number 9.

Once the gate electrodes 7 of the memory cells 1 have been completely formed, in a totally conventional way, according to the invention, a third dielectric layer 10 of the non conform type is deposited, as shown in figure 6B.

Due to the poor filling capacities of the fourth dielectric layer 10, the openings 15 are only "plugged" or closed on top and they are not completely filled in, with the consequent creation of the air-gaps 16 which insulate from each first portion of gate electrodes 7 of the memory cells 1 themselves. As already highlighted, the presence of the air-gaps 16 between the gate electrodes 7 of the memory cells 1 drastically reduces the mean dielectric constant between the gate electrodes 7 of the adjacent memory cells 1, allowing a significant scaling of the reading disturbance relative to cells belonging to adjacent wordlines.

The fourth dielectric layer 10 will instead completely coat the openings 15A since the width D 1 of the openings 15A is wide enough to house contacts between the memory cells 1. In other words, the dielectric layer 10 follows the profile of the sides of the opening 15A, thus resulting to be, inside the openings 15A, of the conform type.

For example, the fourth dielectric layer 10 is formed by a nitride layer or by an oxide layer or by an oxynitride layer with significant over-hang or with low capacity of filling in the slots.

Advantageously, after the formation of the fourth dielectric layer 10 a fifth dielectric layer 11 is deposited with a high capacity of filling in slots as shown in figure 7B.

Advantageously from the combination of the fourth dielectric layer 10 and of the fifth dielectric layer 11, which can be formed separately or by means of a single integrated deposition, the height at which the air-gaps 16 are formed can also be controlled.

Advantageously, the fourth dielectric layer 10 and the fifth dielectric layer 11, if present, are used to form the spacers of the circuitry transistors. In fact the circuitry transistors are more spaced from each other with respect to the memory cells 1 for which they are not affected by the problems of poor filling capacity of the fourth dielectric layer 10, therefore this layer 10 completely coats the gate electrodes of the circuitry transistors and the semiconductor substrate 2 whereon they are formed.

At this point of the process according to the invention, the steps for completing the spacers of the circuitry transistors can be formed by means of three different versions aimed at safeguaring the air-gaps 16 formed on the memory cells 1.

In particular, as shown in figure 8B, on the memory cells 1 a mask 12 is formed, for example of resist, which protects all the memory cells 1 during the etching step of the fourth dielectric layer 10 and of the fifth dielectric layer 11, if present, to form spacers on the side walls of the circuitry transistors and expose portions of the semiconductor substrate 2 not covered by the gate electrodes and spacers of the circuitry. The mask 12 is then removed.

Once the definition is completed of the circuitry transistors has been conventionally completed, for example with further implants to form second portions of the source and drain regions more doped with respect to the first portions of the source and drain regions and after a removal step of the layer 9 the formation of salicide layers in circuitry, if any. This formation of the salicide layer which is not formed in matrix since covered by the fourth dielectric layer 10.

At least one sixth premetal dielectric layer 13 is deposited, as shown in figure 9B.

Further openings 19 are then defined in the sixth premetal dielectric layer 13 to form contacts in the matrix and in the circuitry.

A second version to complete the spacers of the circuitry transistors is shown with reference to figures 10B and 11B.

In particular, the etching step of the fourth dielectric layer 10 and of the fifth dielectric layer 11, if present, for the formation of the spacers of the circuitry transistors is carried out on the whole device without using masks.

Therefore in the portions of the memory electronic device wherein the air-gaps 16 have been created, the thickness of the dielectric layer 10, and of the fifth dielectric layer 11, if present, must be enough to ensure that the spacers etching step leave the air-gaps 16 protected.

Moreover during the etching step of the fourth dielectric layer 10, inside the second openings 15A, spacers 20 are created on the side walls of the memory cells 1.

In particular, the formation step of the spacers 20 of the matrix and of the circuitry spacers leave a surface portion of the of the gate electrodes 7 exposed and a portion 2a of the semiconductor substrate 2 aligned with the spacers 20 and non covered by the gate electrodes and by the spacers, both covered by the dielectric layer 9.

Once the definition of the circuitry transistors has been conventionally completed, for example with further implant steps to form second portions of the source and drain regions aligned with the spacers and more doped with respect to the first portions of the source and drain regions, after a removal step of the dielectric layer 9 from the surface portion of the gate electrodes 7 and from the portion 2a of the semiconductor substrate 2, a salicide layer 14 is formed in circuitry, if any, and on the gate electrodes 7 of the memory cells and on the portions 2a of the semiconductor substrate 2 which are exposed in matrix.

At least one sixth premetal dielectric layer 13 is then deposited on the whole device.

Further openings 19 are then formed in the sixth premetal dielectric layer 13 to form contacts in the matrix and in the circuitry.

A second embodiment to complete the spacers of the circuitry transistors is described with reference to figures 12 and 13.

In particular, the definition of the circuitry spacers is carried out also in matrix with a mask 21 which protects the source regions, i.e. which covers the device portion wherein the air-gaps 16 are formed.

Therefore, after having formed the mask 21, the fourth dielectric layer 10 and the fifth dielectric layer 11 are etched, if present, until portions of the semiconductor substrate 2 non covered by the gate electrodes and by the spacers are exposed, which is then coated by the dielectric layer 9.

Inside the second openings 15A coated by the fourth layer 10, spacers 20 are then formed on the side walls of the memory cells 1 besides spacers on the side walls of the circuitry transistors.

In particular, the formation step of the spacers 20 of the matrix and of the circuitry spacers leaves a surface portion of the gate electrodes 7 exposed and a portion 2a of the semiconductor substrate 2 not covered by the gate electrodes 7 and by the spacers 20 of the memory cells, coated by the dielectric layer 9.

Once the definition of the circuitry transistors has been conventionally completed, for example with further implant steps to form second portions of the source and drain regions more doped with respect to the first portions of the source and drain regions, once the dielectric layer 9 is removed from the surface portion of the gate electrodes 7 and from the portion 2a of the semiconductor substrate 2, a salicide layer 14 is formed in circuitry, if any, and on the gate electrodes 7 of the memory cells and on the portions 2a of the semiconductor substrate 2 which are exposed in matrix.

At least one sixth premetal dielectric layer 13 is then deposited on the whole device.

Further openings 19 are then defined in the sixth premetal dielectric layer 13 to form contacts in the matrix and in the circuitry.

Although the process according to the invention has been described with reference to memory cells of the Flash type, it can be advantageously applied to memories of the EPROM type, Flash EEPROM with NAND or NOR organisation, being one-level or multilevel, said memory cells being provided with a floating gate electrode.

In conclusion, with the process according to the invention, the electrostatic disturbance between cells of adjacent wordlines is scaled down due to the smaller mean dielectric constant of the materials which separate the wordlines.

Advantageously, moreover, the air-gaps 16 having been defined are self-aligned with the wordlines and their formation provides the use of common materials which do not have particular compatibility constraints with the rest of the process, therefore the compatibility with the processes being currently in use is complete and the additional process steps do not involve particular constraints for the definition of the circuitry.

Moreover with the continuous scaling of the non volatile memory electronic devices, the process according to the invention can be advantageously used to improve the characteristics of the devices with matrixes having high density memory matrixes, in particular those with multilevel operation.

The advantages of the process according to the invention are particularly significant for memory devices with NAND configuration, which mainly suffer from reading disturbances linked to the coupling of the floating gate electrodes of adjacent wordlines: for these memories the introduction of the air-gaps 16 according to the invention requires, at the most, the addition of a non critical mask to the conventional process flow.

Advantageously, at the morphologic level, memory electronic devices formed with the process according to the invention can be easily recognised in matrix due to the presence of the air-gaps 16 and the morphology of the layer 10 which is formed by non conform material and is used as protection of the air-gaps 16, being it nitride, oxide or oxynitride.

## Claims

1. Process for manufacturing a non volatile electronic device integrated on a semiconductor substrate (2) which comprises a plurality of non volatile memory cells (1) being matrix-like organised in rows, called wordlines, and columns, called bit lines and an associated circuitry, comprising the steps of:
- forming gate electrodes (7) of said memory cells (1) projecting from said semiconductor substrate (2), each of said gate electrodes (7) comprising a first dielectric layer (3), a floating gate electrode (4), a second dielectric layer (5) and a control gate electrode (6) coupled to a respective word line, at least one first portion of said gate electrodes (7) of said memory cells (1) being separated from each other by first openings (15) of a first width (D),
- forming source and drain regions (8) of said memory cells (1) in said semiconductor substrate (2), said source and drain regions (8) of said memory cells (1) being aligned with said gate electrodes (7) of said memory cells (1),
- forming gate electrodes of transistors of said circuitry projecting from said semiconductor substrate (2), each of said gate electrodes of said circuitry comprising a first dielectric layer of said circuitry and a first conductive layer of said circuitry,
- forming source and drain regions of said transistors in said semiconductor substrate (2), said source and drain regions of said transistors being aligned with said gate electrodes (7) of said transistors, the process being **characterised in that** it comprises the following steps:
- depositing, on the whole device, a third non conform dielectric layer (10) so as to not completely fill in said first openings (15) and to form air-gaps (16) between said gate electrodes belonging to said first portion of said gate electrodes (7) of said memory cells (1).

2. Process for manufacturing a memory electronic device according to claim 1 **characterised in that** said third dielectric layer (10) is formed by a nitride layer or by an oxide layer or by an oxynitride layer.

3. Process for manufacturing a memory electronic device according to claim 1 **characterised in that** said third dielectric layer (10) completely coats said transistors in said circuitry.

4. Process for manufacturing a memory electronic device according to claim 1 or 3, **characterised in that** on said third dielectric layer (10) a fourth dielectric layer (11) having high step coverage is deposited.

5. Process for manufacturing a memory electronic device according to claim 4 **characterised in that** said fourth dielectric layer (11) is formed by an oxide or nitride or oxynitride layer.

6. Process for manufacturing a memory electronic device according to claim 3, **characterised in that** it comprises the steps of:
- etching said third dielectric layer (10) to form spacers on side walls of transistors of said circuitry until at least one portion of said semiconductor substrate (2) is exposed, being covered by a dielectric layer (9) formed on the electronic device before forming said dielectric layer (10).

7. Process for manufacturing a memory electronic device according to any one of the preceding claims, **characterised in that** a second portion of said gate electrodes (7) of said memory cells (1) are separated from each other by second openings (15A) of a second width (D2) greater than said first width (D1), **characterised in that** the third dielectric layer (10) completely coats said second openings (15A).

8. Process for manufacturing a memory electronic device according to claim 6, **characterised in that** during said etching step of said third dielectric layer (10) spacers are formed on the side walls of said gate electrodes of said second portion of said gate electrodes (7) of said memory cells (1) which are inside said second openings (15A), said etching exposing at least one portion (2a) of said semiconductor substrate (2), covered by a dielectric layer (9) formed on the electronic device before forming said dielectric layer (10).

9. Process for manufacturing a memory electronic device according to claim 8, **characterised in that** during said etching step of said third dielectric layer (10) surface portions of said gate electrode (7) are exposed, covered by a dielectric layer (9) formed on the electronic device before forming said dielectric layer (10).

10. Process for manufacturing a memory electronic device according to claim 6 or 8, **characterised in that** before carrying out the etching step of said third dielectric layer (10) a mask (12, 21) is formed at least on said first portion of said gate electrodes (7) of said memory cells (1).

11. Process for manufacturing a memory electronic device according to claim 10, **characterised in that** before carrying out the etching step of said third dielectric layer (10) a mask (12) is formed on all the gate electrodes (7) of said memory cells (1).

12. Process for manufacturing a memory electronic device according to claim 6 or 8, **characterised in that** a siliciuro layer (14) is formed on said exposed portions (2a) of semiconductor substrate (2), after having removed said dielectric layer (9).

13. Process for manufacturing a memory electronic device according to claim 9, **characterised in that** a siliciuro layer (14) is formed on said surface portions of said gate electrodes (7), after having removed said dielectric layer (9).

14. Process for manufacturing a memory electronic device according to claim 8, **characterised in that** a contact is formed in said portion (2a) of said semiconductor substrate (2).

15. Non volatile memory electronic device integrated on a semiconductor substrate (2) comprising a plurality of non volatile memory cells (1) organised in matrix and an associated circuitry, each cell comprising:
- a gate electrode (7) projecting from said semiconductor substrate (2) comprising a first dielectric layer (3), a first conductive layer (4), a second dielectric layer (5) and a second conductive layer (6),
- source and drain regions (8) formed in said semiconductor substrate (2) and aligned with said gate electrodes (7), the device being **characterised in that** at least one portion of said gate electrodes are insulated from each other by air-gaps (16) which are closed on top by a third non conform dielectric layer (10).
